# FASCICULE DE BREVET EUROPEEN

(11) **EP 1 418 161 B1**
(45) Date de publication et mention de la délivrance du brevet: **10.04.2019**
(21) Numéro de dépôt: 03300110.8
(22) Date de dépôt: 08.09.2003
(51) Int. Cl.: C04B 35/581, C23C 4/10, C23C 4/18, C23C 4/12, C04B 35/626, C04B 35/628, H01L 21/48

(54) **Procédé de fabrication d'un substrat en nitrure d'aluminium**
Verfahren zur Herstellung eines Aluminiumnitridsubstrats
Method for the production of an aluminium nitride substrate

(30) Priorité: 26.09.2002 FR 0211898
(43) Date de publication de la demande: 12.05.2004
(73) Titulaire: ALSTOM Transport Technologies, 93400 Saint-Ouen (FR)
(72) Inventeur: Petitbon, M. Alain, 64000 Pau (FR); Ferrato, M. Marc, 65310 Horgues (FR); Jarrige, Jean, 87100 Limoges (FR)
(74) Mandataire: Lavoix

(56) Documents cités:
- US-A- 5 273 699
- US-A- 6 001 761
- US-A- 6 110 853
- DATABASE WPI Section Ch, Week 199409 Derwent Publications Ltd., London, GB; Class L02, AN 1994-068186 XP002243624 & JP 05 088680 A (SANSHA DENKI SEISAKUSHO KK) 9 avril 1993 (1993-04-09)
- DATABASE WPI Section Ch, Week 200054, Derwent Publications Ltd., London, GB; Class J04, AN 1994-147127, XP002243625 & JP 3 100 084 B2 (NISSHIN FLOUR MILLING CO) 16 Octobre 2000

## Description

L'invention se rapporte à un procédé de fabrication d'un substrat en nitrure d'aluminium AlN et notamment à un procédé de fabrication permettant d'obtenir un substrat de faible épaisseur.

Les substrats en AlN sont très utilisés pour supporter les composants électroniques de puissance car ils sont électriquement isolants et bons conducteurs de la chaleur.

De tels substrats en AlN sont habituellement réalisés par frittage et sont commercialement disponibles en 0,635 mm d'épaisseur minimum pour des raisons de tenue mécanique et de déformation pendant la cuisson à haute température. Une telle épaisseur du substrat AlN permet de tenir des tensions de plusieurs dizaines de kiloVolts et est adaptée aux applications de forte puissance, telle que la traction ferroviaire. Cependant, cette épaisseur de 0,635 mm est excessive pour les applications basse tension, tel que les bus à traction électrique, où la surépaisseur du substrat AlN par rapport à l'épaisseur nécessaire pour tenir la tension devient un inconvénient du point de vue du coût et de la résistance thermique.

Aussi, un but de la présente invention est de proposer un procédé de fabrication d'un substrat en AlN permettant notamment d'obtenir des substrats en AlN de 0,1 à 0,5 mm d'épaisseur.

L'invention a donc pour objet un procédé conforme aux revendications.

D'autres états de la technique sont divulgués dans US-A-6 110 853, US 5 273 699 et US 6 001 761.

On comprendra mieux les buts, aspects et avantages de la présente invention, d'après la description donnée ci-après d'un mode de réalisation particulier de l'invention, présenté à titre d'exemple non limitatif.

Dans une première phase du procédé, une poudre d'AlN adaptée pour être projetée au moyen d'une torche plasma est élaborée au moyen des étapes successives suivantes:
- dissolution d'un précurseur d'oxyde d'yttrium Y₂O₃ tel que l'isopropionate d'yttrium ou yttrium isopropoxide dans de l'isopropanol au moyen d'un agitateur.
- dispersion d'une poudre fine et pure d'AlN, possédant des grains de l'ordre de 2 à 3 µm de diamètre, dans la solution obtenue lors de l'étape précédente de manière à obtenir une barbotine d'AlN contenant l'équivalent de 2 à 3% d'oxyde d'yttrium. Cette dispersion de la poudre d'AlN est réalisée par broyage ou par agitation vigoureuse, par exemple au moyen d'une turbine, avec l'aide d'un stabilisant ou d'un surfactant pour que la suspension reste stable jusqu'à l'atomisation.
- atomisation sous atmosphère inerte de la barbotine obtenue précédemment au moyen d'un atomiseur, la température et le débit de pulvérisation de l'atomiseur étant réglés afin que les sphères creuses obtenues ne s'écrasent pas sur les parois de l'atomiseur. Une telle atomisation permet l'obtention d'une poudre formée de sphères creuses dont le diamètre est compris entre 40 et 150 µm, ces sphères creuses étant composées de grains d'AlN recouverts d'une fine couche de précurseur d'oxyde d'yttrium et agglomérés par atomisation.
- tamisage éventuel de la poudre atomisée pour éliminer les fractions trop fines ou trop grosses et ne conserver que les sphères creuses d'AlN dont le diamètre est compris entre 50 et 100 µm.

Dans une seconde phase du procédé, la poudre d'AlN ainsi obtenue est projetée au moyen d'une torche plasma sur un support métallique, par exemple en aluminium, ce dernier étant refroidi par des jets d'air sous pression sur sa face opposée de manière à maintenir une température d'équilibre de l'ordre de 150°C. La torche plasma peut être par exemple une torche à plasma d'arc dont la température peut atteindre 15000 °K ou bien encore une torche à plasma à induction à quelques milliers de °C. Les grains sphériques d'AlN sont projetés dans le plasma avec un débit ajustable et arrivent partiellement fondus, à une vitesse voisine de la vitesse du son, sur le support métallique refroidi pour former une couche quasiment dense. Au cours de cette phase de projection, les grains d'AlN sont protégés de l'oxydation par le précurseur d'oxyde d'yttrium, ce dernier se décomposant dans le plasma pour donner l'oxyde et réagir sur l'AlN pour générer une phase YAG (Yttrium Aluminium Garnet). Le nombre de passage de la torche plasma au-dessus du support métallique est fonction de la surface et de l'épaisseur du substrat AlN désirée, chaque passe permettant le dépôt d'une épaisseur de 40 à 60 µm d'AlN, un balayage avec recouvrement partiel étant réalisé pour obtenir une surface homogène.

Afin de favoriser l'adhérence du dépôt d'AlN en cyclage thermique, une sous couche d'accrochage est éventuellement réalisée sur le support métallique préalablement à la projection de l'AlN. Cette sous-couche d'accrochage sera par exemple, dans le cas d'un support en aluminium, constituée d'une fine couche d'oxyde obtenue par anodisation et possédant une épaisseur de quelques micromètres afin de ne pas trop pénaliser le coût et la résistance thermique. Dans le cas d'un support en cuivre, un nickelage chimique et éventuellement un chromage léger sera préférentiellement réalisé sur le support.

Dans une phase suivante du procédé, le susbtrat d'AlN sur son support métallique est avantageusement recuit à basse température pour relaxer les contraintes résiduelles dues au différentiel entre les coefficients de dilatation du support et de la céramique AlN.

Un tel procédé de fabrication permet ainsi d'obtenir un substrat en AlN dont l'épaisseur peut être comprise entre 0,1 mm et 0,5 mm de façon à être optimisée pour servir de support à des composants électroniques dans les applications basse tension.

Pour améliorer la rugosité superficielle du substrat AlN ainsi obtenu, par exemple pour les applications en électronique de puissance où il est nécessaire de cuivrer la surface du substrat céramique pour y braser des composants semi-conducteurs, la surface du substrat d'AlN peut avantageusement être activée par laser excimère pour lisser la surface, un dépôt électrolytique de cuivre pouvant ensuite être réalisé sur les zones activées.

Ainsi, dans une variante du procédé le précurseur d'oxyde d'yttrium utilisé pourra être de l'hexafluoroacetylacetonate qui sera dissous dans du tetrahydrofuranne au cours de la première étape de la phase de préparation de la poudre d'AlN.

Ainsi, dans d'autres modes de réalisation du procédé selon l'invention, le précurseur d'oxyde utilisé pourra être choisi parmi les précurseurs d'oxyde de cérium, de samarium, de calcium ou des lanthanides. A titre d'exemple, le précuseur d'oxyde choisi pourra être de l'acetylacetonate de samarium qui sera dissous dans un solvant organique comme le tétrahydrofuranne.

## Revendications

1. Procédé de fabrication d'un substrat en nitrure d'aluminium AlN pour son utilisation en tant que support pour des composants électroniques dans des applications basses tensions, **caractérisé en ce qu'**il comporte les étapes successives suivantes:
a) dissolution d'un précurseur d'oxyde sous forme d'un composé organométallique dans un solvant organique pour obtenir une solution,
b) dispersion d'une poudre fine et pure d'AlN dans la solution précédemment obtenue par agitation vigoureuse pour obtenir une suspension,
c) atomisation sous atmosphère inerte de la suspension ainsi obtenue pour obtenir une poudre granulée comportant des grains d'AlN recouverts d'une couche du précurseur d'oxyde,
d) projection, à haute température et à haute vitesse, de la poudre comportant des grains d'AlN recouverts d'une couche du précurseur d'oxyde sur un élément support, en utilisant une torche à plasma et un support métallique, et
**en ce que** le précurseur d'oxyde est choisi parmi les précurseurs oxydes donnant un oxyde formant une phase liquide autour des grains d'AlN, au cours de la projection,
le précurseur d'oxyde étant choisi parmi les précurseurs d'oxyde d'yttrium, de cérium, de samarium, de calcium ou des lanthanides.

2. Procédé selon la revendication 1, **caractérisé en ce que** le précurseur d'oxyde est un précurseur d'oxyde d'yttrium et se décompose dans le plasma au cours de la projection pour donner l'oxyde d'yttrium.

3. Procédé selon les revendications 1 et 2, **caractérisé en ce que** ledit précurseur d'oxyde est un précurseur d'oxyde d'yttrium et **en ce que** la poudre d'AlN obtenue après atomisation comporte l'équivalent de 2 à 3 % en poids d'oxyde d'yttrium.

4. Procédé selon la revendication 3, **caractérisé en ce que** ledit précurseur d'oxyde d'yttrium est de l'isopropionate d'yttrium qui est dissous dans du propanol.

5. Procédé selon l'une quelconque des revendications 1 à 4, **caractérisé en ce que** ledit substrat est obtenu en plusieurs passes sur l'élément support en fonction de l'épaisseur désirée.

6. Procédé selon l'une quelconque des revendications 1 à 5, **caractérisé en ce que** ledit élément support est métallique et est refroidi par jets d'air sous pression lors de l'étape de projection de la poudre d'AlN.

7. Procédé selon l'une quelconque des revendications 1 à 6, **caractérisé en ce que** le substrat d'AlN obtenu par la projection de poudre d'AlN sur l'élément support est recuit à basse température.

## Patentansprüche

1. Verfahren zur Herstellung eines AlN Aluminiumnitridsubstrats für seine Verwendung als Träger für elektronische Komponenten in Kleinspannungsanwendungen, **gekennzeichnet dadurch, dass** es die folgenden aufeinanderfolgenden Schritte umfasst:
a) Auflösen eines Oxidvorläufers in Form einer organometallischen Verbindung in einem organischen Lösemittel, um eine Lösung zu erhalten,
b) Dispergieren eines feinen und reinen AlN Pulvers in der vorangehend erhaltenen Lösung unter heftigem Rühren, um eine Suspension zu erhalten,
c) Atomisieren der so erhaltenen Suspension in inerter Atmosphäre, um ein granuliertes Pulver umfassend mit einer Schicht aus Oxidvorläufer bedeckte AlN Körnchen zu erhalten,
d) Projektion, bei hoher Temperatur und hoher Geschwindigkeit, des Pulvers umfassend mit einer Schicht aus Oxidvorläufer bedeckte AlN Körnchen auf ein Trägerelement, unter Verwendung eines Plasmabrenners und eines metallischen Trägers,
und dadurch, dass der Oxidvorläufer ausgewählt ist aus Oxidvorläufern, welche Oxid ergeben, welches, während der Projektion, eine flüssige Phase um die AlN Körnchen herum bildet, wobei der Oxidvorläufer ausgewählt ist aus Yttrium-, Cerium-, Samarium-, Calcium- oder Lanthanoid- Oxid-Vorläufern.

2. Verfahren gemäß Anspruch 1, **gekennzeichnet dadurch, dass** der Oxidvorläufer ein Yttriumoxidvorläufer ist und sich während der Projektion im Plasma zersetzt, um das Yttriumoxid zu ergeben.

3. Verfahren gemäß den Ansprüchen 1 und 2, **gekennzeichnet dadurch, dass** der Oxidvorläufer ein Yttriumoxidvorläufer ist und dass das nach dem Atomisieren erhaltene AlN Pulver ein Gewichtsäquivalent von 2 bis 3 % Yttriumoxid umfasst.

4. Verfahren gemäß Anspruch 3, **dadurch gekennzeichnet, dass** der Yttriumoxidvorläufer Yttriumisopropionat ist, welches in Propanol gelöst ist.

5. Verfahren gemäß einem der Ansprüche 1 bis 4, **dadurch gekennzeichnet, dass** das Substrat in mehreren Durchgängen, in Abhängigkeit von der gewünschten Dicke, auf dem Trägerelement erhalten wird.

6. Verfahren gemäß einem der Ansprüche 1 bis 5, **dadurch gekennzeichnet, dass** das Trägerelement metallisch ist und während des Schritts der Projektion des AlN Pulvers durch Druckluftstrahlen gekühlt wird.

7. Verfahren gemäß einem der Ansprüche 1 bis 6, **dadurch gekennzeichnet, dass** das mittels Projektion des AlN Pulvers auf das Trägerelement erhaltene AlN Substrat bei niedriger Temperatur getempert wird.

## Claims

1. Method for the production of an aluminium nitride AIN substrate for use as a support for electronic components in low-voltage applications, **characterised in that** it comprises the following successive steps:
a) dissolving an oxide precursor in the form of an organometallic compound in an organic solvent in order to obtain a solution,
b) dispersing a fine, pure AIN powder in the solution previously obtained by vigorous stirring in order to obtain a suspension,
c) atomising the resulting suspension under an inert atmosphere in order to obtain a granulated powder comprising grains of AIN coated with a layer of the oxide precursor,
d) spraying, at high temperature and at high speed, the powder comprising grains of AIN coated with a layer of the oxide precursor onto a support element, using a plasma torch and a metal support, and
**in that** the oxide precursor is chosen from the oxide precursors that yield an oxide which forms a liquid phase around the grains of AIN during the spraying,
the oxide precursor being chosen from the oxide precursors of yttrium, cerium, samarium, calcium or the lanthanides.

2. Method according to claim 1, **characterised in that** the oxide precursor is an yttrium oxide precursor and decomposes in the plasma during spraying to yield yttrium oxide.

3. Method according to claims 1 and 2, **characterised in that** said oxide precursor is an yttrium oxide precursor and **in that** the AIN powder obtained after atomisation comprises the equivalent of from 2 to 3% by weight yttrium oxide.

4. Method according to claim 3, **characterised in that** said yttrium oxide precursor is yttrium isopropionate which is dissolved in propanol.

5. Method according to any one of claims 1 to 4, **characterised in that** said substrate is obtained in a plurality of passes over the support element according to the desired thickness.

6. Method according to any one of claims 1 to 5, **characterised in that** said support element is made of metal and is cooled by jets of compressed air during the step of spraying the AIN powder.

7. Method according to any one of claims 1 to 6, **characterised in that** the AIN substrate obtained by spraying AlN powder onto the support element is annealed at low temperature.
